# EUROPÄISCHE PATENTSCHRIFT

(11) **EP 0 316 480 B1**
(45) Veröffentlichungstag und Bekanntmachung des Hinweises auf die Patenterteilung: **16.02.1994**
(21) Anmeldenummer: 87117136.9
(22) Anmeldetag: 20.11.1987
(51) Int. Cl.: H03F 3/30

(54) **Monolithisch integrierter Leistungsbreitbandverstärker**
Monolithic integrated wideband power amplifier
Amplificateur de puissance à large bande intégré monolithiquement

(43) Veröffentlichungstag der Anmeldung: 24.05.1989
(73) Patentinhaber: Deutsche ITT Industries GmbH, 79108 Freiburg (DE)
(72) Erfinder: Novotny, Bernd, D-7803 Emmendingen (DE); Schilling, Harald, D-7800 Freiburg i. Br. (DE)

(56) Entgegenhaltungen:
- US-A- 4 451 799
- IEEE INTERNATIONAL SOLID-STATE CIRCUITS CONFERENCE, Band 27, Conferenz Nr. 31, San Francisco, 22.-24. Februar 1984, pages 288-289,355, IEEE, New York, US; W.F. DAVIS et al.: "A monolithic P-channel JFET QUAD operational amplifier"

## Beschreibung

Die Erfindung betrifft einen monolithisch integrierten Leistungsbreitbandverstärker entsprechend dem Oberbegriff des Anspruches. Er enthält eine Gegentaktendstufe mit bipolaren NPN- Transistoren und eine eingangsseitige Differenzstufe, an deren Eingang die Eingangsspannung als Differenzsignal angelegt wird.

Die Gegentaktendstufe enthält eine Endstufe, eine diese ansteuernde Treiberstufe und einen Arbeitspunkteinsteller für die beiden in Serie geschalteten Transistoren der Endstufe. Diese sind ein erster und ein zweiter Transistor, deren Kollektor-Emitter-Strecken gleichsinnig in Serie geschaltet sind und an deren Verbindungspunkt die Ausgangsspannung abgegriffen wird. Der erste Transistor ist dabei mit seinem Kollektor am einen Pol einer Betriebsspannungsquelle angeschlossen und der Emitter des zugehörigen zweiten Transistors ist mit deren anderen Pol gekoppelt.

Die Treiberstufe besteht aus einem dritten Transistor, dessen Emitter mit dem anderen Pol gekoppelt ist und dessen Basis mit der Basis des zweiten Transistors leitend über eine gemeinsame Basisleitung verbunden ist. Der Kollektor des dritten Transistors ist über einen ersten Widerstand mit dem einen Pol der Betriebsspannungsquelle verbunden und ferner direkt auf die Basis des ersten Transistors der Gegentaktendstufe geführt.

Die Ansteuerung der Treiberstufe erfolgt durch ein Ausgangssignal der Differenzstufe das die gemeinsame Basisleitung des zweiten und dritten Transistors speist. Zur Ansteuerung der Basis des ersten Transistors wird das von der Differenzstufe stammende Ausgangssignal mittels des Treibertransistors als Kollektorsignal in der Phase invertiert.

Der Arbeitspunkteinsteller enthält einen ohmschen Widerstand, mit dem der durch die beiden Endstufentransistoren fließende Ruhestrom und auch die Ruhespannung eingestellt wird.

Im Tagungsband (= Digest of Technical Papers), "IEEE International Solid-State-Circuits Conference", Band 27 (1984), Seiten 288-289 und 355, zur Tagung Nr.31 vom 22. bis 24. Februar 1984 in San Fransisco, ist unter dem Titel: "A Monolithic-P-Channel JFET QUAD Operational Amplifier" unter anderem auch eine bipolare Gegentaktendstufe beschrieben, deren Ausgangsstufe durch zwei in Serie geschaltete und im Gegentakt betriebene NPN-Leistungstransistoren gebildet wird. Ein zum unteren Ausgangstransistor parallel angesteuerter zweiter NPN-Transistor, dessen Signalauskopplung im Kollektorzweig erfolgt, dient der Steuersignalinvertierung für den oberen NPN-Leistungstransistor. Der Eingang des Operationsverstärkers wird durch eine Differenzstufe gebildet, die im Eingang ein JFET-Transistorpaar und im Ausgang eine Stromdifferenzschaltung enthält, die die Gegentaktendstufe über eine Zwischenstufe ansteuert.

In US 4 451 799 ist eine direkt gekoppelte Gegentaktendstufe beschrieben, deren in Serie geschaltete NPN-Ausgangstransistoren im B-Gegentaktbetrieb arbeiten. Für die Ansteuerung der Ausgangstransistoren und die übrige Schaltung werden PNP-Transistoren benötigt. Der untere NPN-Ausgangstransistor ist hierzu mit einem PNP-Transistor als LIN-Kombination zusammengeschaltet und verhält sich daher wie ein PNP-Leistungstransistor. Die Ansteuerung der LIN-Kombination und des oberen NPN-Ausgangstransistors kann somit gleichphasig über eine einzige Treiberschaltung erfolgen.

Ein Leistungsbreitbandverstärker nach dem Oberbegriff des Anspruchs 1 ist in dem RCA-Handbuch, "RCA Linear Integrated Circuits", Technical Series IC-41, 1967, Seiten 263 bis 266 beschrieben. Insbesondere Fig. 236 auf Seite 264 zeigt einen derartigen monolithisch integrierten Leistungsbreitbandverstärker, nämlich einen Operationsverstärker mit einer Leistungs-Gegentaktendstufe.

Nachteilig bei dieser Schaltungsanordnung ist, daß es sich bei ihr um eine Operationsverstärkerschaltung handelt, die bekanntlich eine hohe Leerlaufverstärkung aufweist. Die gewünschte Betriebsverstärkung wird dabei mittels einer äußeren galvanischen Signalrückführung vom Ausgang auf den Eingang des Operationsverstärkers erreicht, die gegenkoppelnd wirkt. Ferner wird bei der Änderung des Lastwiderstands am Treibertransistor nicht nur der Querstrom durch die beiden Endstufentransistoren verändert, sondern auch noch die Endstufenverstärkung.

Der in den Ansprüchen gekennzeichneten Erfindung liegt daher die Aufgabe zugrunde, die vorbeschriebene Schaltungsanordnung so weiterzubilden, daß die Gesamtverstärkung und der Arbeitspunkt der Endstufe unabhängig voneinander und ohne Gegenkopplungstechnik durch interne Schaltungsmaßnahmen einstellbar ist. Ferner sollen die Signalverzerrungen auch bei sehr hohen Frequenzen und kapazitiven Lasten möglichst klein sein.

Eine bevorzugte Anwendung des erfindungsgemäßen Leistungsbreitbandverstärkers ergibt sich als Leitungstreiber in digitalen Systemen dür Takt- oder Datensignale, die über kapazitiv belastete Leitungen weitergegeben werden. Dabei kann es sich um Takt- oder Datenleitungen innerhalb oder zwischen monolithisch integrierten Schaltungen handeln.

Für digitalisierte Fernsehsysteme werden derzeit beispielsweise Taktfrequenzen bis 40 MHz verwendet, wobei diese Obergrenze laufend erhöht wird. Damit bei diesen Taktfrequenzen die Takt- oder die Datenflanken nicht verzerrt werden, was Fehler bei der Datenübernahme zur Folge hätte, ist es erforderlich, daß der Leistungsbreitbandverstärker eine sehr hohe Grenzfrequenz aufweist. Die Betriebsverstärkung liegt dabei beispielsweise in einem Bereich von 0,5 bis 20, was einem Ausgangssignal von 0,1 V bis 3 V (Spitze zu Spitze) entspricht.

Ein Vorteil des erfindungsgemäßen Leistungsbreitbandverstärkers besteht darin, daß der eingestellte Arbeitspunkt und die Verstärkung nahezu unabhängig von der jeweiligen Kristalltemperatur sind.

Die Erfindung wird nun anhand der Figuren der Zeichnungen näher erläutert.
Fig. 1 zeigt das Schaltbild eines Ausführungsbeispiels des Leistungsbreitbandverstärkers nach der Erfindung,
Fig. 2 zeigt das Schaltbild eines Ausführungsbeispiels der in Fig. 1 enthaltenen Konstantstromsenke,
Fig. 3 zeigt zwei Layouts von Basiszonen von Teiltransistoren nach Fig. 1,
Fig. 4 zeigt schematisch ein Layout mit Schnittbild für Teiltransistoren mit Emittergegenkopplungswiderstand,
Fig. 5 zeigt schematisch ein Layout mit Schnittbild für eine andere Teiltransistoranordnung,
Fig. 6 zeigt schließlich schematisch ein Layout mit Schnittbild für eine weitere Teiltransistoranordnung mit Emittergegenkopplungswiderstand.

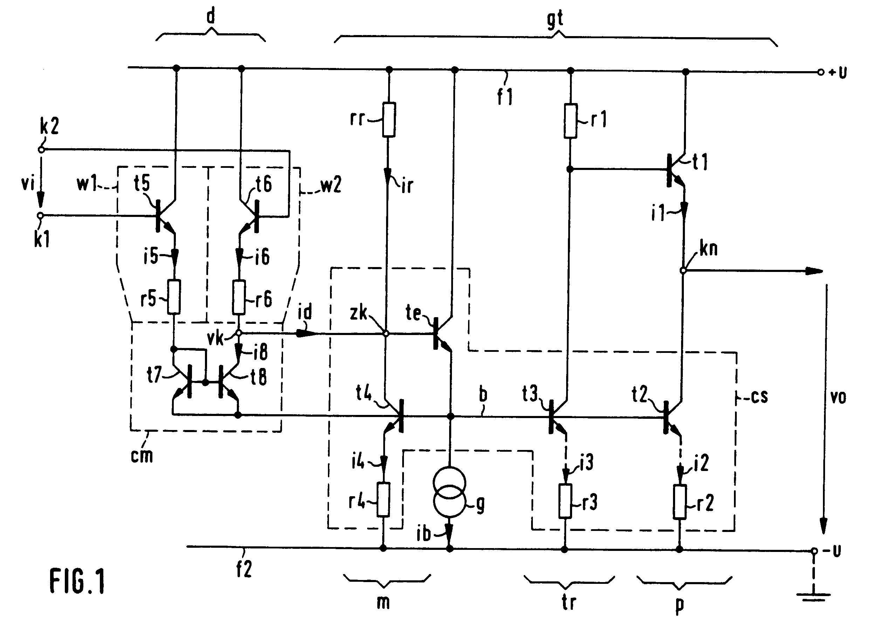

In Fig. 1 ist als Ausführungsbeispiel die Schaltung eines erfindungsgemäßen Leistungsbreitbandverstärkers dargestellt. Mit dem einen Pol +u der Versorgungsspannungsquelle ist die erste Versorgungsleitung f1 und mit dem anderen Pol -u die zweite Versorgungsleitung f2 verbunden, die zugleich an Massepotential liegen kann. Den Ausgang bildet der Ausgangsknoten kn, an dem die Ausgangsspannung vo abgegriffen wird. Als dessen Ruhespannung kann beispielsweise die Spannungsmitte zwischen dem einen und dem anderen Pol +u, -u eingestellt sein.

Den Eingang des Leistungsbreitbandverstärkers bildet die erste und die zweite Eingangsklemme k1, k2, zwischen denen im Betrieb die Eingangsspannung vi angelegt wird. Es handelt sich bei ihr um eine Differenzspannung, die z.B. einer Stufe mit emittergekoppelter Logik (=ECL) entstammen kann und z.B. einen Hub von +/-0,4 V aufweist, wobei jeweils das Potential einer der beiden Eingangsklemmen k1, k2 gleich dem des einen Pols +u der Versorgungsspannungsquelle sein kann. Die erste und die zweite Eingangsklemme k1, k2 sind zugleich Eingänge der Differenzstufe d, die als Ausgangssignal den Differenzstrom id erzeugt, dessen Polarität und Größe von der Eingangsspannung vi direkt abhängen.

Mit dem Differenzstrom id wird der Zwischenknoten zk, der als Eingang der Gegentaktendstufe gt dient, gespeist. Diese besteht aus dem Arbeitspunkteinsteller m, der den Einstellwiderstand r zur Ruhepotentialeinstellung der Ausgangsspannung vo enthält. Ferner enthält die Gegentaktendstufe gt die Treiberstufe tr und die Endstufe p, die als Leistungstransistoren den ersten und den zweiten zueinander gleichsinnig in Serie geschalteten Transistor t1, 2t enthält. Der Emitter des ersten Transistors t1 und der Kollektor des zweiten Transistors t2 liegen am Ausgangsknoten kn.

Der erste Transistor t1 ist ein Emitterfolger, dessen Kollektor direkt und dessen Basis über den ersten Widerstand mit der ersten Versorgungsleitung f1 verbunden ist. Dieser ist zugleich der Lastwiderstand des Treibertransistors, nämlich des dritten Transistors t3, dessen Basis über die gemeinsame Basisleitung b mit der Basis des zweiten Transistors t2 verbunden ist.

Der Emitter des zweiten Transistors t2 ist über den zweiten Widerstand r2 und der Emitter des dritten Transistors t3 über den dritten Widerstand r3 an der zweiten Versorgungsleitung f2 angeschlossen; damit wirken diese beiden Widerstände gegenkoppelnd. Ferner ist an die gemeinsame Basisleitung b die Basis des vierten Transistors t4 angeschlossen, der zum Arbeitspunkteinsteller m gehört. Auch der Emitter des vierten Transistors t4 ist gegengekoppelt, indem er über den vierten Widerstand r4 an die zweite Versorgungsleitung f2 angeschlossen ist. Der Kollektor des vierten Transistors ist mit dem Zwischenknoten zk, der seinerseits über den Einstellwiderstand rr an die erste Versorgungsleitung f1 angeschlossen ist, und mit der Basis des Entlastungstransistors te verbunden, dessen Emitter auf die gemeinsame Basisleitung b geführt ist und dessen Kollektor an der ersten Versorgungsleitung f1 liegt.

Der jeweilige Widerstandswert der drei Emittergegenkopplungswiderstände r2, r3, r4 ist umgekehrt proportional zur Emitterfläche des zugehörigen Transistors t1, t3, t4. Diese sechs Schaltelemente und der Entlastungstransistor te bilden die Dreifachkonstantstromsenke cs. Deren Eingang ist der Zwischenknoten zk, der zum einen mit dem Differenzstrom id und zum anderen über den Einstellwiderstand rr mit dem Einstellstrom ir gespeist ist. Entsprechend dem gewünschten Verhältnis der Emitterflächen ist der Emitterstrom i2 des zweiten Transistors größer als der Emitterstrom i3 des dritten Transistors t3, und dieser ist größer als der Emitterstrom i4 des vierten Transistors t4. Beispielsweise verhalten sich bei einem Emitterflächenverhältnis von 20:10:1 die Emitterströme i2, i3, i4 ebenfalls wie 20:10:1.

Wenn der Differenzstrom id gleich null ist, dann bestimmt der Einstellstrom ir allein den Spannungsabfall am ersten Widerstand r1 und damit die Ausgangsruhespannung am Ausgangsknoten kn. Ferner ist der gemeinsame Ruhestrom des ersten und des zweiten Transistors durch dessen Emitterstrom i2 vorgegeben. Durch Änderung des Einstellwiderstandes rr, was z.B. durch eine Verschiebung des Widerstandskontaktes mittels einer geänderten Kontaktmaske möglich ist, läßt sich somit die Ausgangsruhespannung verändern. Sie kann beispielsweise auf die halbe Versorgungsspannung eingestellt werden. Die Ausgangsruhespannung ist in diesem speziellen Fall völlig temperaturunabhängig.

Die Temperaturkompensation der Ruhespannung ergibt sich daraus, daß die Spannung, die am Einstellwiderstand rr liegt und den Einstellstrom ir erzeugt, die Versorgungsspannung abzüglich der beiden Basis-Emitter-Flußspannungen des Entladetransistors te und des vierten Transistors t4 ist. Der Treiberstrom i3, der streng proportional zum Einstellstrom ir ist, bedingt die Ausgangsruhespannung und erzeugt am ersten Widerstand r1 einen Spannungsabfall, der nur halb so groß ist wie derjenige am Einstellwiderstand rr. Zum Spannungsabfall am ersten Widerstand r1 addiert sich die Basis-Emitter-Flußspannung der ersten Transistors t1.

Zum gesamten Spannungsabfall am Arbeitspunkteinsteller gehören also ein definierter ohmscher Spannungsabfall (an rr) und die Flußspannung zweier Diodenstrecken, und zur Ruhespannung am Ausgang, die gleich der halben Versorgungsspannung ist, gehört also ein halb so großer ohmscher Spannungsabfall (wie an rr) und die Flußspannung einer Diodenstrecke. Damit ist das Verhältnis der Ruhespannung zur Versorgungsspannung unabhängig von der Temperatur, aber auch unabhängig von der Versorgungsspannung. Wird für die Ruhespannung ein anderer Wert als die halbe Versorgungsspannung gewählt, so ist die Kompensation nicht mehr ideal, aber immer noch gut.

Der Spannungsabfall an den drei Emittergegenkopplungswiderständen r2, r3, r4 ist für diese Betrachtung der Temperaturabhängigkeit vernachlässigbar, denn er beträgt z.B. nur 50 mV. Dieser Wert reicht indessen zur Symmetrierung der dreifachen Konstantstromsenke cs voll aus, da die der drei Transistoren t2, t3, t4 im wesentlichen durch ihre genaue Layoutanpassung, insbesondere ihrer Basis- und Emitterflächen, erreicht wird.

Die Differenzstufe d ist der Schaltungsteil, der aus der Eingangsspannung vi den Differenzstrom id erzeugt, der am Zwischenknoten zk dem Einstellstrom ir überlagert wird und somit den Signalanteil darstellt. Die erste Eingangsklemme k1 liegt am ersten Spannungs-Strom-Wandler w1, dessen Ausgang den Eingang des Stromspiegels cm speist. Die zweite Eingangsklemme k2 liegt am Eingang des Spannungs-Strom-Wandlers w2, dessen Ausgang mit dem Ausgang des Stromspiegels cm über den Verzweigungsknoten vk, der den Differenzstrom id liefert, verbunden ist.

Im einzelnen besteht der erste Spannungs-Strom-Wandler w1 eingangsseitig aus dem ersten Impedanzwandler, der den fünften Transistor t5 als Emitterfolger enthält. Dessen Emitter ist über den fünften Widerstand r5 auf den niederohmigen Eingang des Stromspiegels cm geschaltet, also auf die direkte Verbindung von Basis und Kollektor des siebten Transistors t7, an der ferner die Basis des achten Transistors t8 angeschlossen ist. Der jeweilige Emitter des siebten und des achten Transistors t7, t8 liegt an der gemeinsamen Basisleitung b der Dreifach-Konstantstromsenke cs. Durch den Spannungsabfall am fünften Widerstand r5 wird der erste Vergleichsstrom i5 erzeugt, der gespiegelt als Kollektorstrom i8 des achten Transistors t8 erscheint.

Der zweite Spannungs-Strom-Wandler w2 ist gleich wie der erste aufgebaut und enthält eingangsseitig den zweiten Impedanzwandler, der aus dem als Emitterfolger geschalteten sechsten Transistor t6 besteht. Der Emitter dieses Transistors ist über den sechsten Widerstand r6 auf den Verzweigungsknoten vk geführt. Dadurch, daß dieser über den Zwischenknoten zk an der Basisemitterstrecke des Entlastungstransistors te liegt, liegt sein Potential bezüglich des Fußpunkts des Stromspiegels cm fest. Somit wird durch den Spannungsabfall am sechsten Widerstand r6 der zweite Vergleichsstrom i6 erzeugt, der in den Verzweigungsknoten vk fließt. Andererseits wird dieser durch den Ausgangsstrom i8 des Stromspiegels cm belastet, so daß eine Stromdifferenzbildung stattfindet. Sind der erste und der zweite Vergleichsstrom i5, i6 einander nicht gleich, so fließt der überschüssige Strom als Differenzstrom id in den Zwischenknoten zk oder wird von ihm abgeführt.

Die Stärke des Differenzstromes id ist also sowohl von der Eingangsspannung vi als auch vom jeweiligen Wert des fünften und des sechsten Widerstandes r5, r6 abhängig. Mittels eines Maskenabgleichs dieser Widerstände, z.B. durch Verschiebung der Kontaktöffnungen, ähnlich wie beim Einstellwiderstand rr, lassen sich also diese beiden zueinander gleichen Widerstände in ihrem Wert gemeinsam verändern. Damit kann auf einfache Weise das Verhältnis des Differenzstromes id zur Eingangsspannung vi eingestellt werden.

Die Summe der beiden Vergleichsströme i5, i6 fließt in die gemeinsame Basisleitung b und muß von dort zum anderen Pol -u der Versorgungsspannung geleitet werden. Dies erfolgt durch den Belastungsstrom ib, mit dem die gemeinsame Basisleitung b beispielsweise über einen Widerstand oder die Konstantstromsenke g belastet wird. Dabei wird die Stärke des Belastungsstromes ib vorteilhafterweise so gewählt, daß der Entlastungstransistor te ebenfalls belastet wird, und zwar mit einem Strom, der etwa gleich dem mittleren Wert des ersten Vergleichsstroms i5 ist. Bei gleicher Stromdichte im Entlastungstransistor te und siebten Transistors t7 ist das Eingangspotential des Stromspiegels cm gleich dem Potential des Zwischenknotens zk.

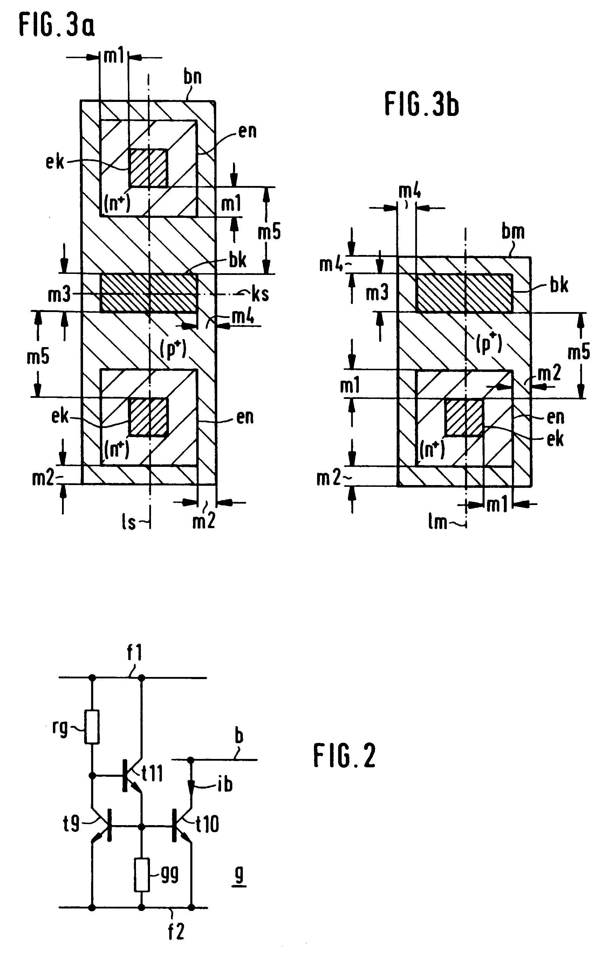

Fig. 2 zeigt ein Ausführungsbeispiel der Konstantsstromsenke g zur Erzeugung des Belastungsstroms ib. Sie enthält den aus dem neunten und zehnten Transistor t9, t10 gebildeten Stromspiegel mit dem Transistor t11 als Entlastungstransistor, dessen Basisemitterstrecke der Kollektorbasisstrecke des neunten Transistors t9 parallelgeschaltet ist. Der Eingangsstrom dieses Stromspiegels wird durch den Widerstand rg bestimmt, der zwischen die erste Versorgungsleitung f1 und den Kollektor des neunten Transistors geschaltet ist, der zusammen mit dem elften Transistor den Eingang des Stromspiegels bildet. Die Emitter des neunten und zehnten Transistors t9, t10 liegen gemeinsam an der zweiten Versorgungsleitung f2, während der Kollektor des zehnten Transistors t10 and der gemeinsamen Basisleitung b der Dreifach-Konstantstromsenke cs liegt und den Belastungsstrom ib aus ihr zieht. Damit der Entlastungstransistor t11, dessen Kollektor an der ersten Versorgungsleitung f1 liegt, ausreichend belastet ist, ist der Belastungswiderstand gg zwischen den Emitter des elften Transistors und die zweite Versorgungsleitung f2 geschaltet.

Wie bereits die Ausgangsruhespannung von der Temperatur unabhängig ist, so ist auch die Signalamplitude von der Temperatur unabhängig. Der Differenzstrom id hängt nur von der Spannungsdifferenz der ersten und zweiten Eingangsklemme k1, k2 und dem jeweiligen Wert des fünften und sechsten Widerstands r5, r6 und deren Temperaturkoeffizient ab. Dabei ist die Annahme gerechtfertigt, daß die Basisemitterspannung des fünften und des sechsten Transistors t5, t6 unabhängig von der Temperatur einander gleich sind, denn die Stromdichten in diesen Transistors sind nahezu gleich, weil der Betrag der Eingangsspannung vi höchstens 500 mV beträgt. Der Differenzstrom id hat also einen Temperaturkoeffizient, der umgekehrt gleich dem des fünften oder sechsten Widestands r5, r6, aber auch umgekehrt gleich dem des ersten Widerstandes r1 ist.

Der Signalhub der Ausgangsspannung vo entspricht genau dem Spannungsabfall des Treiberstromes i3 und durch den gleichen Temperaturkoeffizient der drei mitintegrierten Widerstände r1, r5, r6 ist der Spannungsabfall am ersten Widerstand r1 genau proportional zur Spannungsdifferenz an den beiden Eingangsklemmen k1, k2, so daß der Hub der Ausgangsspannung vo unabhängig von der Temperatur ist.

Aus den gleichen Gründen hat die Versorgungsspannung oder die gemeinsame Gleichspannung an den beiden Eingangsklemmen k1, k2 keinen Einfluß auf den Hub der Ausgangsspannung vo, sofern Begrenzungseffekte oder extreme Betriebszustände vermieden werden.

Sollen derartige Leistungsbreitbandverstärker auch für die Verarbeitung hochfrequenten Signale geeignet sein, so ist nicht nur die Schaltung selbst nach Hochfrequenzgesichtspunkten aufzubauen, sondern diese sind auch bei der monolithischen Integration, insbesondere beim Layout, zu berücksichtigen. So enthält beispielsweise die Schaltung nach Fig. 1 ausschließlich bipolare NPN-Transistoren, weil deren Transitfrequenz erheblich größer als diejenige von lateralen PNP-Transistoren ist. Ferner ist die Stromdichte der Transistoren so zu wählen, daß die Transitfrequenz im Bereich ihres Maximalwertes liegt. Die erforderlichen Ströme, insbesondere die großen Ausgangströme der Endstufe p, werden durch die Parallelschaltung von Teiltransistoren ermöglicht, so daß die Stromdichte des einzelnen Teiltransistors immer im Bereich des Optimums liegt.

Sowohl die Schaltung als auch das Layout ist im Hinblick auf möglichst kleine parasitäre Kapazitäten, wobei ganz besonders auf den starken Einfluß der Kollektorbasiskapazität der Transistoren als Miller-Kapazität zu achten ist, zu konzipieren. Ein Qualitätsmerkmal für gutes Layout ist somit wegen der Miller-Kapazität eine möglichst kleine gemeinsame Basis-Kollektorfläche und wegen der kapazitiven Verkopplung des Kollektors mit dem Substrat eine möglichst kleine Kollektorfläche.

Auch die Eingangskapazität der Transistoren, die aus der Basis-Emitter-Kapazität besteht, muß möglichst klein sein. Der Verkleinerung des Emitters sind indessen Grenzen gesetzt, weil zu große Stromdichten die Transitfrequenz herabsetzen und den Transistor in seinen elektrischen Eigenschaften entarten lassen.

Ferner ist auf die Kontaktierung der verschiedenen Zonen zu achten. Bei kleinen Kontakten nimmt der Kontaktwiderstand zu und bildet mit den parasitären Kapazitäten einen Tiefpaß, der die obere Grenzfrequenz herabsetzt. Schließlich ist auch der Einfluß der Bahnwiderstände der einzelnen Zonen zu berücksichtigen, insbesondere der n⁻-leitenden Kollektorzone.

Da Kreuzungen in der Leiterbahnebene nicht möglich sind und üblicherweise durch niederohmige Zonen realisiert werden, deren Bahnwiderständen indessen nicht vernachlässigbar sind und mit parasitären Kapazitäten ein schädliches Tiefpaßverhalten ergeben, sind derartige Zonen daher möglichst zu vermeiden, wobei aber bei der Leitungsführung über Umwege deren parasitäre Kapazität ebenfalls zu berücksichtigen ist.

Alle diese Gesichtspunkte sind bei dem anhand der Fig. 3 bis 6 nun zu erläuternden, bevorzugten Layout berücksichtigt, das zusammengefaßt wie folgt konzipiert ist:
Die n⁻-leitende Kollektorzone enthält eine niederohmige, n⁺-leitende Kontaktierungszone, welche die Basis möglichst umgreift und die Kollektorkontakte enthält (damit kann der Bahnwiderstand für die in die Kollektorzone injizierten Ladungsträger klein gehalten werden); zur Reduktion der Basis-Kollektor-Kapazität ist eine Doppelemitterstruktur vorgesehen ist, bei der die Basisgebiete zweier Basiszonen so zusammengefügt sind, daß einen einziger Basiskontakt für deren Ansteuerung ausreicht; und die Parallelschaltung der oben erwähnten Teiltransistoren erfolgt durch direkte oder indirekte Parallelschaltung der entsprechenden Kontakte.

Die Fig. 3a zeigt schematisch das Layout der Basisteilzone bn, die eine Doppelemitterstruktur enthält. Die Basisteilzone bn ist eine symmetrische rechteckförmige Struktur, die die lange und die kurze Symmetrieachse ls, ks aufweist. Innerhalb der Basisteilzone bn an den beiden schmalseitigen Enden befindet sich jeweils die quadratische Emitterteilzone en, die in die Basisteilzone bn eingebettet ist, von dieser aber nicht überdeckt wird. In der Flächenmitte der Emitterteilzone en befindet sich der Emitterkontakt ek, der als Minimalkontakt ausgeführt ist, bei dem also der Kontaktwiderstand noch klein genug, der Abstand zum Rand der Emitterteilzone en den ersten Minimalabstand m1 aber nicht überschreitet. Der Randabstand der Emitterteilzone en zum benachbarten Rand der Basisteilzone bn ist gleich dem zweiten Minimalabstand m2.

Im Kreuzungspunkt der kurzen und der langen Symmetrieachse ls, ks befindet sich innerhalb der Basisteilzone bn der Basiskontakt bk. Er ist rechteckförmig, seine Längsrichtung erstreckt sich in Richtung der kurzen Symmetrieachse ks, und er ist so breit wie der dritte Minimalabstand m3. In der Richtung der kurzen Symmetrieachse wird der Basiskontakt bk innerhalb der Basisteilzone bn so lang wie möglich gemacht, jedoch darf der vierte Minimalabstand m4 nicht unterschritten werden.

Schließlich ist die Größe der Basisteilzone bn dadurch bestimmt, daß der Abstand der beiden Emitterkontakte ek vom jeweiligen Rand des basiskontakts bk den fünften Minimalabstand m5 einhalten muß.

Die einzelnen Minimalabstände sind Sicherheitsabstände, die dadurch bedingt sind, daß die einzelnen Prozeßschritte zum Teil Über- oder Untermaße entstehen lassen, ferner Toleranzen berücksichtigt werden müssen, die durch Justierfehler oder Verzerrungen von Masken oder durch die Prozeßabläufe und deren Schwankungen entstehen, und die sich schließlich aus der erforderlichen elektrischen Durchschlagfestigkeit der einzelnen Bereiche ergeben.

Der Emitterkontakt ek ist mit enger Schraffur gezeigt, die schräg von rechts oben nach links unten verläuft. Der Basiskontakt bk ist mit enger Schraffur gezeigt, die schräg von links oben nach rechts unten verläuft. Der Leitungstyp des relativ niederohmigen p⁺-leitenden Basismaterials ist innerhalb der Basisteilzone bn mittels des in runden Klammern stehenden p mit hochgestelltem Pluszeichen angegeben. Entsprechend ist das relativ niederohmige n⁺-leitende Material der Emitterteilzone en mit (n⁺) angegeben.

Fig. 3b zeigt das Basiselement bm, das nur noch eine einzige Emitterteilzone en enthält. Es ist nahezu gleich der einen Hälfte der Basisteilzone bn, und zwar entspricht deren eine Hälfte, die von einer der Basisschmalseiten und der kurzen Symmetrieachse ks begrenzt wird und die Emitterteilzone en mit dem Emitterkontakt ek sowie die eine Hälfte des Basiskontaktes bk enthält, demjenigen Teil des Basiselements bm, das von der emitterseitigen Basisschmalseite und der zu ihrer parallelen Mittellinie des Basiskontaktes bk begrenzt wird. Dabei ist der emitterabgewandte Randabstand des Basiskontaktes bk des Basiselementes bm gleich dem jeweiligen Abstand der Basiskontaktschmalseite vom Rand der Basisteilzone bn oder dem des Basiselements bm. Die wirksamen Basis-Emitter-Flächen der beiden Basisstrukturen der Fig. 3 sind somit bis auf ein einfaches ganzzahliges Vielfaches, nämlich zwei, einander gleich. Damit lassen sie sich zur Erzeugung von Transistoren mit gepaarten Eigenschaften, aber mit unterschiedlichen Strömen, zusammenschalten.

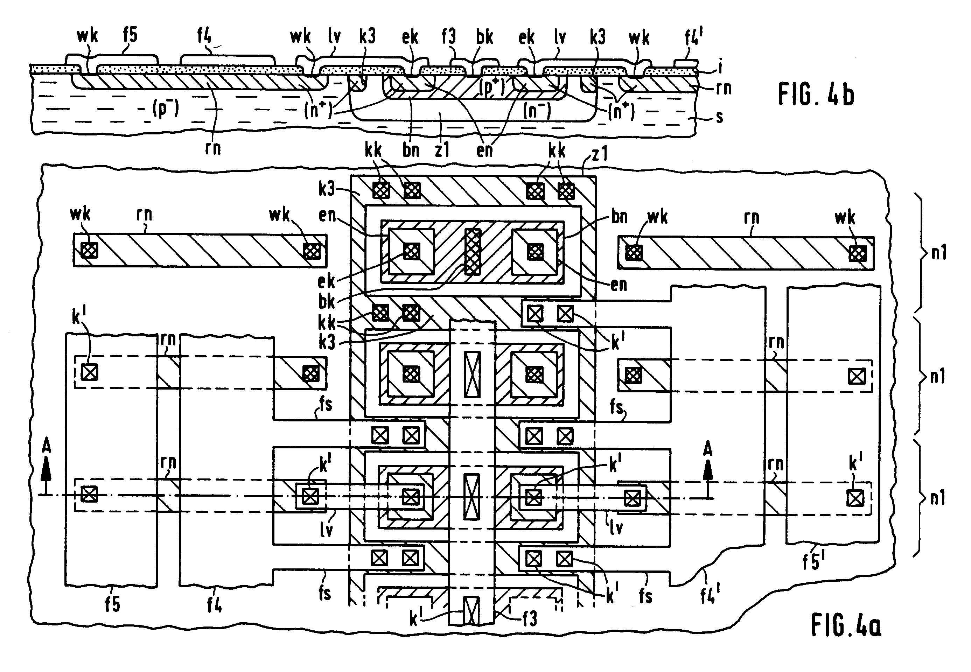

Fig. 4a zeigt schematisch das Layout für einen Transistor, der aus der Parallelschaltung von Teiltransistoren n1 aufgebaut ist und als Basisstrukturen Basisteilzonen nach Fig. 3a enthält.

Da der Transistor über einen Emitterwiderstand gegengekoppelt sein soll, sind alle Emitterteilzonen en der Teiltransistoren n1 über jeweils eine der Widerstandszonen rn gegengekoppelt. Die rechteckförmige n⁺-leitenden Widerstandszonen rn werden im selben Verfahrensschritt wie die Emitterteilzonen en erzeugt. Die Basisteilzonen bn liegen parallel zu ihrer langen Symmetrieachse ls nebeneinander in der hochohmigen n⁻-leitenden Kollektorzone z1. In diese sind, wie bei nach dem Planarverfahren hergestellten Transistoren üblich, die Basisteilzonen bn eingelassen, die somit voneinander isoliert sind. Am Rand der Kollektorzone z1 ist in diese die n⁺-leitende Kontaktierungszone eingelassen, die ferner Kontaktierungsstege zwischen benachbarten Basisteilzonen bn aufweist. So sind diese von der Kontaktierungszone k3 ringförmig umgeben. Sie wird im selben Verfahrensschritt wie die Widerstandszonen rn und die Emitterteilzonen en erzeugt. In Fig. 4a und den nachfolgenden Figuren sind die n⁺-leitenden Zonen durch die weite Schrägschraffur von links oben nach rechts unten verdeutlicht.

In die Kontaktierungszone k3 sind entlang der Längsseite der Basisteilzonen bn Kollektorkontakte kk eingelassen. Durch deren seitliche Anordnung wird die Kollektorzone z1 an vielen Stellen kontaktiert, ohne deren Fläche wesentlich zu vergrößern. Die Widerstandszonen rn sind außerhalb der Kollektorzone längs der langen Symmetrieachse ls angeordnet und enthalten an ihrem jeweiligen schmalseitigen Ende den Widerstandskontakt wk. Die Widerstandszonen rn sind untereinander und von der Kollektorzone z1 elektrisch getrennt, da jede Zone für sich in das schwach p⁻-leitende Substrat s eingebettet ist.

Die Parallelschaltung der emittergegengekoppelten Teiltransistoren n1 erfolgt in Fig. 4 durch fünf Leitungen. Die erste Leitung f3 verbindet die Basiskontakte bk der Basisteilzonen bn. Die zweite Leitung f4 verbindet auf der einen Seite der kurzen Symmetrieachse ks alle Kollektorkontakte kk miteinander; auf der anderen Seite dient dazu die dritte Leitung f4′. Entsprechend verbindet die vierte Leitung f5 auf der einen Seite der kurzen Symmetrieachse ks alle von den Teiltransistoren abgewandten Widerstandskontakte wk miteinander; auf der anderen Seite der kurzen Symmetrieachse ks dient hierzu die fünfte Leitung f5′. Die noch nicht zusammengeschalteten Widerstandskontakte wk der Widertandszonen sind über jeweils eine Verbindungsleitung lv mit dem zugehörigen Emitterkontakt ek verbunden.

Die Leitungen f4, f4′ überqueren die Widerstandszonen rn und weisen seitliche kammartige Fortsetzungen fs auf, die mit den Kollektorkontakten kk verbunden sind. Dabei sind jeweils alle Kollektorkontakte kk eines halben Kontaktierungssteges an den Fortsatz fs der Leitung f4 bzw. f4′ angeschlossen. Außerhalb der in Fig. 4a gezeigten Anordnung sind die Leitungen f4, f4′ bzw. f5, f5′ jeweils miteinander verbunden.

Fig. 4b zeigt schematisch zur Verdeutlichung die Schnittansicht der Fig. 4a in Richtung der Linie AA. Es ist deutlich zu sehen, wie die Widerstandszone rn und die Kollektorzone z1 in das p⁻-leitende Substrat voneinander isoliert eingebettet sind. Ferner ist deutlich zu erkennen, wie in die Kollektorzone z1 einmal die Basisteilzone bn und die diese ringförmig umgreifende Kontaktierungszone k3 eingebettet sind. Die verschiedenen Zonen sind durch die gepunktet gezeichnete Isolierschicht i abgedeckt, die nur die verschiedenen Kontaktöffnungen zur Kontaktierung der darunter liegenden Zonen aufweist.

Die gegenseitige Isolierung der n⁻-oder N⁺-leitenden Zonen im Substrat s kann durch das Auftreten von n-leitenden Kanälen an der Oberfläche des Substrats s gestört werden. Dies kann durch eine einfache Maßnahme verhindert werden, die in Fig. 4 allerdings nicht gezeigt ist. Und zwar reicht es aus, wenn an der Oberfläche des Substrats s eine p⁺-leitende Kanalstopzone angebracht wird, weil diese einen parasitären Kanal unterbricht. Die Kanalstopzonen können dabei netzförmig miteinander verbunden sein und an der Oberfläche des Substrats s alle Flächen ausfüllen, die noch "leer" sind.

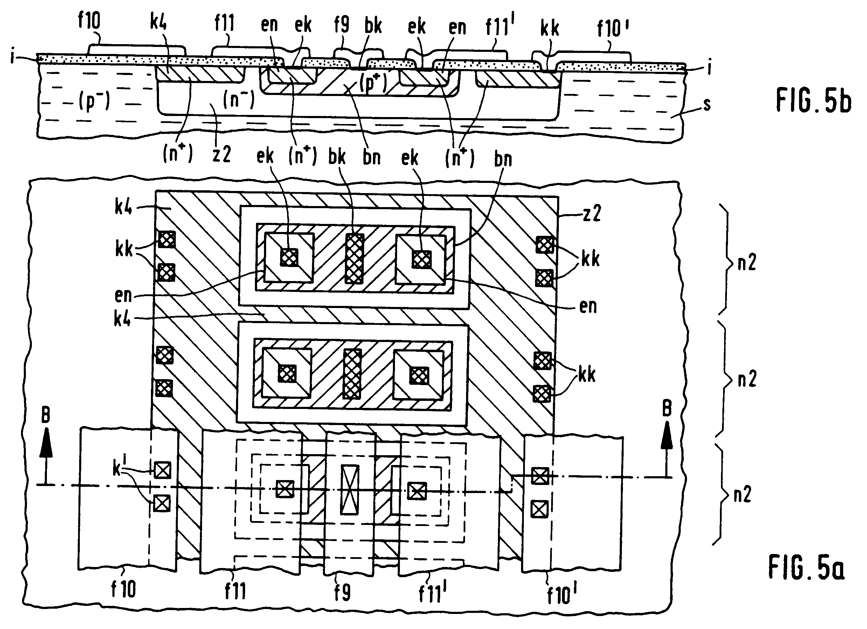

Fig. 5a zeigt ein Layout von parallelgeschalteten Teiltransistoren n2, die ebenfalls die Basisteilzonen bn mit Doppelemitter enthalten. Anders als in Fig. 4 enthält die Kollektorzone z2 jeweils an den beiden Stirnseiten der Basisteilzonen bn die Kollektorkontakte kk. Diese befinden sich innerhalb der Kollektorkontaktierungszone k4, die am Rand der Kollektorzone z2 in diese eingelassen ist. Da sich die Kollektorkontakte kk an der Stirnseite befinden, können die Stege der Kollektorzone z2 und der Kontaktierungszone k4 zwischen den einzelnen Basisteilzonen bn schmaler gehalten werden als in Fig. 4. Allerdings ist die Kollektorzone z2 in Richtung der langen Symmetrieachse ls im Vergleich zu Fig. 4 deutlich größer, weil zwischen der gemeinsamen Basisleitung f9 und der gemeinsamen Kollektorleitung f10, f10′ noch die gemeinsame Emitterleitung f11, f11′ eingefügt ist.

Bei den Teiltransistoren n2 von Fig. 5 ist keine Emittergegenkopplung vorgesehen. Somit entfallen die Widerstandszonen rn, so daß die Leitungen f11, f11′, die mit den Leitungen f5, f5′ von Fig. 4 vergleichbar sind, nunmehr über die Emitterkontakte ek verlaufen und somit zwischen den beiden Leitungen f10, f10′ liegen. In Fig. 4 verlaufen dagegen die Leitungen f5, f5′ außerhalb des von den Leitungen f4, f4′ gebildeten Zwischenraumes. Daher ist in Fig. 5 der Abstand des Randes der Kollektorzone z2 von der Schmalseite der Basisteilzonen bn größer als in Fig. 4.

Die minimalen Abstände zwischen den Leitungen f10, f11; f10′, f11′; f9, f11; f9, f11′ ergeben sich wie oben erläutert, und die Breite der Emitterleitung f11, f11′ muß so groß sein, daß der durch sie bedingte Spannungsabfall vernachlässigbar ist. Die größere Entfernung der Kollektorkontakte kk von der Basisteilzone bn wird dadurch ausgeglichen, daß die Kontaktierungszone k4 die Basisteilzone bn möglichst dicht umschließt und daher im Bereich der Kollektorkontakte kk einen niederohmigen breiten Streifen innerhalb der Kollektorzone z2 ausbildet.

Zur Verdeutlichung dient wieder Fig. 5b, die schematisch die Schnittansicht entlang der Linie BB von Fig. 5a zeigt. Sie enthält wieder als gepunktete Schicht dargestellt die Isolierschicht i mit den verschiedenen Kontaktöffnungen. Deutlich zu sehen ist auch die breitere Kollektorzone z2 mit der ebenfalls verbreiterten Kontaktierungszone k4 im Bereich der Kollektorkontakte kk.

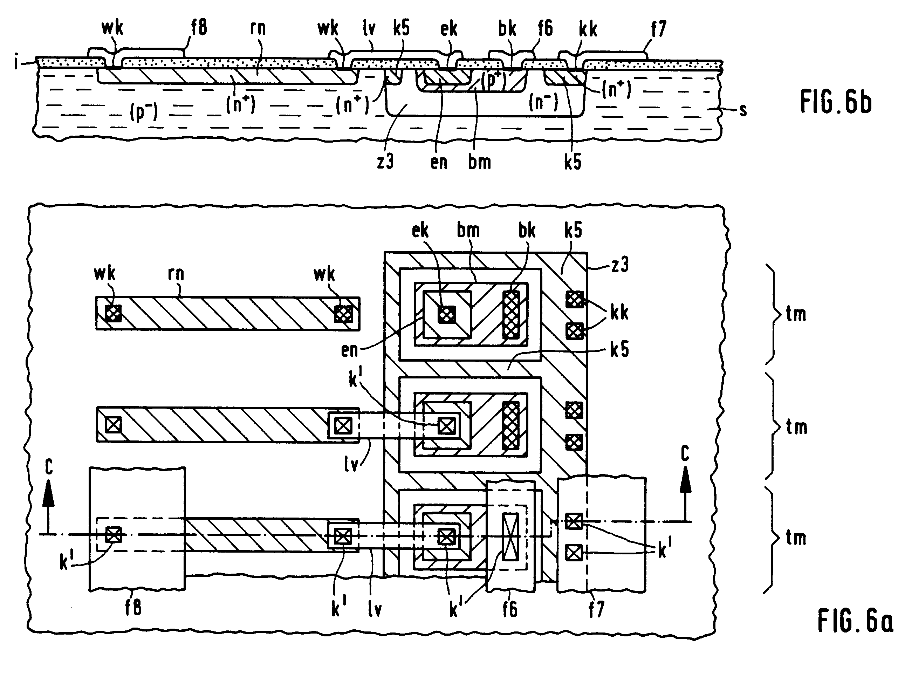

Fig. 6 zeigt schließlich schematisch das Layout parallelgeschalteter weiterer Teiltransistoren tm, die als Basisstruktur das Basiselement bm enthalten. Die Emitterteilzone en der Basiselemente bm ist dabei jeweils zur Emittergegenkopplung an die Widerstandszone rn über die Verbindungsleitung lv angeschlossen.

Die Basiselemente bm liegen gleichsinnig ausgerichtet zu ihrer Symmetrielinie lm nebeneinander in der rechteckförmigen Kollektorzone z3. Diese enthält wie in den Fig. 4 und 5 an ihrem Rand die niederohmige n⁺-leitende Kontaktierungszone k5, die auch als Verbindungssteg zwischen den einzelnen Basiselementen bm ausgebildet ist.

Die Kollektorkontakte kk sind längs derjenigen Schmalseite des Basiselements bm ausgebildet, die dem Basiskontakt bk benachbart ist. Damit der Abstand zwischen der gemeinsamen Basisleitung f6 und der gemeinsamen Kollektorleitung f7 ausreichend ist, sind die Kollektorzone z3 und mit ihr die Kontaktierungszone k5 im Bereich der Kollektorkontakte etwas breiter im Vergleich zur anderen Schmalseite des Basiselements bm ausgebildet.

Fig. 6b stellt wieder zur Verdeutlichung eine Schnittansicht entlang der Linie CC der Fig. 6a dar. Die Oberfläche des Substrats ist durch die gepunktet dargestellte Isolierschicht i abgedeckt, die nur dort Öffnungen aufweist, wo darunterliegende Zonen kontaktiert werden sollen.

In den Fig. 4a,5a, 6a ist die Kontaktierungsfläche k′ im Bereich der Leitungen als Rechteck mit Diagonalen gezeichnet.

Ein Vergleich der Teiltransistoren n1; n2; tm zeigt, daß die Teiltransistoren n1 die kleinste relative Kollektorfläche aufweisen. Da zudem wegen der Doppelemitterstruktur ein aus diesen bestehender Transistor für große Ströme geeignet und auch eine Emittergegenkopplung vorgesehen ist, wird dieser vorzugsweise für den zweiten Transistor t2 der Endstufe p verwendet. Wegen des Hubs an seinem Kollektor ist dieser Transistor besonders empfindlich gegenüber einer Miller-Kapazität.

Ein aus Teiltransistoren n2 bestehender Transistor ist für den ersten Transistor t1 der Endstufe p geeignet, der dort als Emitterfolger dient. Da er mit seinem Kollektor am festen Potential der ersten Versorgungsleitun f1 angeschlossen ist, kann sich keine Miller-Kapazität ausbilden. Der dritte Transistor t3 und der vierte Transistor t4 sind mittels des dritten bzw. des vierten Widerstands r3, r4 am Emitter gegengekoppelt und als Teil der Dreifach-Konstantstromsenke cs mit dem zweiten Transistor t2 gepaart. Da die Ströme der Treiberstufe und des Arbeitspunkteinstellers wesentlich geringer sind als wie die der Endstufe, ist die Verwendung von Doppelemitterstrukturen mit ihren aufwendigen Anschlußleitungen nicht erforderlich. Daher ist der dritte und der vierte Transistor t3, t4 aus Teiltransistoren tm nach Fig. 6 zusammengesetzt. Der Transistor t4 umfaßt dabei mindestens einen dieser Teiltransistoren tm. Die gemeinsame Basisleitung b der Dreifachkonstantstromsenke cs wird dabei durch die elfte Leitung f6, die mit der ersten Leitung f3 verbunden ist, gebildet. Der zweiten Versorgungsleitung f2 entspricht dabei die vierte und fünfte Leitung f5, f5′, an die die dreizehnte Leitung f8 angeschlossen ist, die z.B. auf dem gemeinsamen Massepotential liegen.

Durch die Maßnahmen der Fig. 3 bis 6 ergibt sich der weitere Vorteil, daß insbesondere die Gegentaktendstufe gt mit ihren großflächigen Transistoren ein sehr kompaktes Layout aufweist, welches die genaue Paarung der Transistoreigenschaften erlaubt, ohne indessen ihr Hochfrequenzverhalten zu beeinträchtigen. Andere Schaltungsteile, beispielsweise die Differenzstufe d oder die Konstantstromsenke g, bei denen es weniger auf die Verstärkungseigenschaften bei hohen Frequenzen ankommt, können auch PNP-Transistoren oder MOS-Transistoren enthalten, sofern der Herstellungsprozeß dies ermöglicht und eine Verwendung derartiger Transistoren von der Schaltungsfunktion her sinnvoll ist.

## Patentansprüche

1. Monolithisch integrierter Leistungsbreitbandverstärker
mit einer aus bipolaren NPN-Transistoren bestehenden Gegentaktendstufe (gt) und
mit einer eingangsseitigen Differenzstufe (d), an deren Eingänge eine Eingangsspannung (vi), anzulegen ist,
wobei die Gegentaktstufe (gt) folgende Merkmale hat:
- eine Endstufe (p), die einen ersten und einen zweiten Transistor (t1, t2) enthält, deren Kollektor-Emitter-Strecken gleichsinnig in Serie geschaltet sind und deren Verbindungspunkt der Ausgangsknoten (kn) für die Ausgangsspannung (vo) ist, wobei der Kollektor des ersten Transistors (t1) am einen Pol (+u) einer Betriebsspannungsquelle liegt und der Emitter des zweiten Transistors (t2) mit deren anderem Pol (-u) gekoppelt ist,
- eine Treiberstufe (tr), die einen dritten Transistor (t3) mit folgenden elektrischen Verbindungen enthält:
-- der Emitter des dritten Transistors (t3) ist mit dem anderen Pol (-u) gekoppelt,
-- die Basis des dritten Transistors (t3) ist mit der Basis des zweiten Transistors (t2) über eine gemeinsame Basisleitung (b) verbunden, die ferner mit dem Ausgang (vk) der Differenzstufe (d) gekoppelt ist, und
-- der Kollektor des dritten Transistors (t3) ist mit der Basis des ersten Transistors (t1) und über einen ersten Widerstand (r1) mit dem einen Pol (+u) verbunden, und
- die Gegentaktendstufe (gt) enthält ferner einen Arbeitspunkteinsteller (m) mit einem ohm'schen Widerstand für die Endstufe (p),
gekennzeichnet durch folgende Merkmale:
- der Arbeitspunkteinsteller (m) enthält einen Einstellwiderstand (rr), der zwischen dem einen Pol (+u) und einem Zwischenknoten (zk) liegt, an dem der Kollektor eines vierten Transistors (t4), dessen Basis mit der gemeinsamen Basisleitung (b) verbunden ist, und die Basis eines Entlastungstransistors (te) angeschlossen ist, dessen Emitter mit der gemeinsamen Basisleitung (b) verbunden ist und dessen Kollektor mit dem einen Pol (+u) gekoppelt ist,
- die Differenzstufe (d) erzeugt an ihrem Ausgang (vk) einen Differenzstrom (id), dessen Wert proportional zur Eingangsspannung (vi) ist, und der über eine Verbindungsleitung auf den Zwischenknoten (zk) geführt ist, wobei der Zwischenknoten über den vierten Transistor (t4) mit der gemeinsamen Basisleitung (b) gekoppelt ist,
- der Emitter des zweiten bzw. des dritten bzw. des vierten Transistors (t2, t3, t4) liegt über einen zweiten bzw. dritten bzw. vierten Widerstand (r2, r3, r4) am anderen Pol (-u), wobei deren jeweiliger Wert umgekehrt proportional zur Fläche des zugehörigen Emitters ist, und
- der gemeinsamen Basisleitung (b) ist ein Belastungsstrom (ib) entnommen.

2. Monolithisch integrierter Leistungsbreitbandverstärker nach Anspruch 1, dadurch gekennzeichnet, daß die Größe des Differenzstroms (id) mittels eines fünften und eines gleichen sechsten Widerstandes (r5, r6) eingestellt ist.

3. Monolithisch integrierter Leistungsbreitbandverstärker nach Anspruch 2, dadurch gekennzeichnet, daß die Differenzstufe (d) aufweist:
- einen ersten Spannungs-Stromwandler (w1) mit einem ersten Impedanzwandler, der eingangsseitig an einer ersten Eingangsklemme (k1) angeschlossen ist und der mittels des ihm nachgeschalteten fünften Widerstandes (r5) einen ersten Vergleichsstrom (i5) erzeugt,
- einen zweiten Spannungs-Stromwandler (w2) mit einem zweiten Impedanzwandler, der eingangsseitig an einer zweiten Eingangsklemme (k2) angeschlossen ist und der mittels des ihm nachgeschalteten sechsten Widerstandes (r6) einen zweiten Vergleichsstrom (i6) erzeugt, und
- einen Stromspiegel (cm), dessen Eingang mit dem ersten Vergleichsstrom (i5) gespeist ist und dessen Ausgang an einem Verzweigungsknoten (vk) liegt, der mit dem zweiten Vergleichsstrom (i6) gespeist und mit dem Zwischenknoten (zk) verbunden ist.

4. Monolithisch integrierter Leistungsbreitbandverstärker nach Anspruch 3, dadurch gekennzeichnet,
- daß der erste bzw. der zweite Impedanzwandler jeweils ein aus einem fünften bzw. einem sechsten Transistor (t5, t6) bestehender Emitterfolger ist, an dessen jeweiligem Emitter der fünfte bzw. sechste Widerstand (r5, r6) angeschlossen ist,
- daß der Stromspiegel (cm) aus einem siebten und einem achten Transistor besteht, deren Basen miteinander und mit dem Kollektor des siebten Transistors (t7) verbunden sind,
- daß der Fußpunkt des Stromspiegels (cm) an der gemeinsamen Basisleitung (b) liegt und
- daß der fünfte, sechste, siebte und achte Transistor (t5, t6, t7, t8) jeweils vom gleichen Leitungstyp wie die Transistoren der Gegentaktendstufe (gt) sind.

5. Monolithisch integrierter Leistungsbreitbandverstärker nach Anspruch 4, dadurch gekennzeichnet, daß der Belastungsstrom (ib) mittels einer Konstantstromsenke (g) eingestellt ist, dessen Wert so gewählt ist, daß über den Entlastungstransistor (te) ein Strom fließt, der etwa gleich dem ersten Vergleichsstrom (i5) ist.

6. Monolithisch integrierter Leistungsbreitbandverstärker nach einem der Ansprüche 1 bis 5, dadurch gekennzeichnet, daß das Layout mindestens eines der planaren bipolaren NPN-Gegentaktendstufen-Transistoren (t1, t2) N parallelgeschaltete Teiltransistoren (n1; n2) mit folgenden Merkmalen enthält:
- die Teiltransistoren (n1; n2) enthalten jeweils
-- eine rechteckige p⁺-leitende Basisteilzone (bn),
-- zwei gleiche n⁺-leitende Emitterteilzonen (en), die innerhalb der Basisteilzone (bn) symmetrisch zu einer durch diese gebildeten kurzen und zu einer durch diese ebenfalls gebildeten langen Symmetrieachse (ks, ls) angeordnet sind und die in ihrer Mitte jeweils einen Emitterkontakt (ek) aufweisen, und
-- einen auf der kurzen Symmetrieachse (ks) in Längsrichtung sich erstreckenden Basiskontakt (bk), und
- die N Basisteilzonen (bn) liegen parallel zur langen Symmetrieachse (ls) ausgerichtet nebeneinander innerhalb einer n⁻-leitenden rechteckigen Kollektorzone (z1; z2),
-- diese weist eine Vielzahl von Kollektorkontakten (kk) auf, die entweder neben und zwischen den Längsseiten oder längs der beiden Schmalseiten benachbarter Basisteilzonen (bn) angeordnet sind, und
-- diese enthält mindestens im Bereich der Kollektorkontakte (kk) eine n⁺-leitende Kontaktierungszone (k3; k4), die ferner innerhalb der Kollektorzone (z1; z2) die jeweilige Basisteilzone (bn) ringförmig umschließt.

7. Monolithisch integrierter Leistungsbreitbandverstärker nach einem der Ansprüche 1 bis 5, dadurch gekennzeichnet, daß das Layout mindestens eines der planaren bipolaren NPN-Gegentaktendstufen-Transistoren (t1, t2) einen einzigen oder M parallelgeschaltete Teiltransistoren (tm) mit folgenden Merkmalen enthält:
- ein rechteckiges p⁺-leitendes Basiselement (bm) mit einer Symmetrielinie (lm) in dessen Längsrichtung,
- eine Emitterteilzone (en), die innerhalb des Basiselements (bm) symmetrisch zur Symmetrielinie (lm) liegt und die in ihrer Mitte einen Emitterkontakt (ek) aufweist,
- einen Basiskontakt (bk), der symmetrisch zur Symmetrielinie (lm) innerhalb des Basiselements (bm) liegt und dessen Längsrichtung sich senkrecht zu ihr erstreckt und
- eine gemeinsame n⁻-leitende rechteckige Kollektorzone (z3), in der das eine oder die zu den Symmetrielinien (lm) gleichsinnig parallel angeordneten M Basiselemente (bm) liegen und
-- mindestens je Basiselement (bm) einen Kollektorkontakt (kk), der innerhalb der Kollektorzone (c3) längs der dem Basiskontakt (bk) benachbarten Basisschmalseite liegt, wobei die Kollektorzone (z3) mindestens im Kontaktierungsbereich eine n⁺-leitende Kontaktierungszone (k5) aufweist, die ferner innerhalb der Kollektorzone (z3) das jeweilige Basiselement (bm) ringförmig umschließt.

8. Monolithisch integrierter Leitungsbreitbandverstärker nach einem der Ansprüche 1 bis 7, dadurch gekennzeichnet, daß
- das Layout der planaren bipolaren NPN-Gegentaktendstufen-Transistoren (t1, t2) gemäß Anspruch 6 ausgeführt ist,
- der Transistor (t3) der Treiberstufe (tr) und der Transistor (t4) des Arbeitspunkteinstellers (m) jeweils ein Layout gemäß Anspruch 7 haben,
- alle Teiltransistoren (n1; n2; tm) untereinander gleiche Emitterteilzonen (en), untereinander gleiche Emitterkontakte (ek), untereinander gleiche Basiskontakte (bk) und untereinander gleiche Kollektorkontakte (kk) enthalten,
- die eine Hälfte der Basisteilzone (bn), die von einer der Basisschmalseiten und der kurzen Symmetrieachse (ks) begrenzt wird und die die Emitterteilzone (en) mit dem Emitterkontakt (ek) und die eine Hälfte des Basiskontakts (bk) enthält, demjenigen Teil des Basiselements (bm) gleich ist, das von der emitterseitigen Basisschmalseite und der zu ihr parallelen Mittellinie des Basiskontaktes (bk) begrenzt wird, und
- der emitterabgewandte Randabstand des Basiskontaktes (bk) des Basiselements (bm) gleich dem jeweiligen Randabstand der Basiskontaktschmalseite vom Rand der Basisteilzone (bn) oder dem des Basiselements (bm) ist.

9. Monolithisch integrierter Leistungsbreitbandverstärker nach mindestens einem der Ansprüche 1 bis 8, dadurch gekennzeichnet, daß das Layout des planaren bipolaren zweiten, drittem und vierten Widerstandes (r2, r3, r4) folgende Merkmale aufweist:
- der zweite, dritte bzw. vierte Widerstand (r2, r3, r4) besteht aus jeweils mindestens einer von gleichen rechteckigen n⁺-leitenden Widerstandszonen (rn), von denen jeweils eine an die zugehörige Emitterteilzone (en) des zweiten bzw. des dritten bzw. des vierten Transistors (t2, t3, t4) angeschlossen ist,
- jede Widerstandszone (rn) enthält an den beiden Schmalseiten je einen Widerstandskontakt (wk),
- die Widerstandszonen (rn) sind jeweils in Längsrichtung und in Richtung der langen Symmetrieachse (ls) oder der Symmetrielinie (lm) parallel zueinander ausgerichtet und jeweils an dem einen Widerstandskontakt (wk) über eine Verbindungsleitung (lv) mit dem zugehörigen Emitterkontakt (ek) und an jeweils dem anderen Widerstandskontakt (wk) mit einer zum anderen Pol (-u) führenden Leitung (f2; f5, f5'; f6) verbunden, und
- die Widerstandszonen (rn) und die Kollektorzone (z1; z2; z3) liegen jeweils getrennt im p⁻-leitenden Substrat (s).

10. Monolithisch integrierter Leistungsbreitbandverstärker nach einem der Ansprüche 1 bis 9, dadurch gekennzeichnet, daß das Layout mindestens eines der planaren bipolaren NPN-Gegentaktendstufen-Transistoren (t1, t2) folgende Merkmale aufweist:
- die Fläche der Emitterteilzone (en) ist eine Minimalfläche,
- die Emitterkontakte (ek) und die Widerstandskontakte (wk) sind zueinander flächengleiche Minimalkontakte,
- die Abstände der Emitterkontakte (ek) vom Rand der zugehörigen Emitterteilzone (en) bzw. die Abstände der Emitterteilzone (en) vom zugehörigen Rand der Basisteilzone (bn) oder dem des Basiselements (bm) sind erste bzw. zweite Minimalabstände (m1, m2),
- die Schmalseite des Basiskontakts (bk) ist ein dritter Minimalabstand (m3),
- der minimale Abstand des Basiskontakts (bk) zum zugehörigen Rand der Basisteilzone (bn) oder dem des Basiselements (bm) ist ein vierter Minimalabstand (m4) und
- der Abstand des Basiskontakts (bk) zum Emitterkontakt (ek) ist ein fünfter Minimalabstand (m5).

## Claims

1. A monolithic integrated wideband power amplifier
with a push-pull output stage (gt) consisting of bipolar NPN transistors, and
with a differential stage (d) at the input end to whose inputs an input voltage (vi) must be applied,
with the push-pull output stage (gt) having the following features:
- an output stage (p) comprising a first transistor (t1) and a second transistor (t2) whose collector-emitter paths are connected in series in the same direction and whose junction point is the output node (kn) for the output voltage (vo), with the collector of the first transistor (t1) connected to one terminal (+u) of a supply-voltage source, and the emitter of the second transistor (t2) coupled to the other terminal (-u) of the supply-voltage source,
- a driver stage (tr) comprising a third transistor (t3) with the following electric connections:
-- The emitter of the third transistor (t3) is coupled to the other terminal (-u) of the supply-voltage source;
-- the base of the third transistor (t3) is connected to the base of the second transistor (t2) by a common base lead (b) which is also coupled to the output (vk) of the differential stage (d), and
-- the collector of the third transistor (t3) is connected to the base of the first transistor (t1) and, through a first resistor (r1), to said one terminal (+u) of the supply-voltage source, and
- the push-pull output stage (gt) further includes an operating-point setter (m) with a resistor for the output stage (p),
characterized by the following features:
- The operating-point setter (m) includes a setting resistor (rr) interposed between said one terminal (+u) of the supply-voltage source and an intermediate node (zk) to which are connected the collector of a fourth transistor (t4), whose base is connected to the common base lead (b), and the base of a load-reducing transistor (te) having its emitter connected to the common base lead (b) and having its collector coupled to said one terminal (+u) of the supply-voltage source;
- the differential stage (d) delivers at its output (vk) a differential current (id) whose value is proportional to the input voltage (vi), and which is supplied via an interconnection to the intermediate node (zk), which is coupled via the fourth transistor (t4) to the common base lead (b);
- the emitters of the second, third, and fourth transistors (t2, t3, t4) are connected to the other terminal (-u) of the supply-voltage source via a second resistor (r2), a third resistor (r3), and a fourth resistor (r4), respectively, whose values are inversely proportional to the area of the associated emitter, and
- a load current (ib) is taken from the common base lead (b).

2. A monolithic integrated wideband power amplifier as claimed in claim 1, characterized in that the value of the differential current (id) is set by means of a fifth resistor (r5) and a sixth resistor (r6) equal in value to the fifth resistor (r5).

3. A monolithic integrated wideband power amplifier as claimed in claim 2, characterized in that the differential stage (d) comprises:
- a first voltage-to-current converter (w1) with a first impedance converter having its input connected to a first input terminal (k1) and supplying a first reference current (i5) via the fifth resistor (r5), which follows the first impedance converter.
- a second voltage-to-current converter (w2) with a second impedance converter having its input connected to a second input terminal (k2) and supplying a second reference current (i6) via the sixth resistor (r6), which follows the second impedance converter, and
- a current mirror (cm) whose input is supplied with the first reference current (i5), and whose output is connected to a branch point (vk) which is supplied with the second reference current (i6) and connected to the intermediate node (zk).

4. A monolithic integrated wideband power amplifier as claimed in claim 3, characterized in
- that the first and second impedance converters are emitter followers consisting a fifth transistor (t5) and a sixth transistor (t6), respectively, having their respective emitters connected to the fifth resistor (r5) and the sixth resistor (r6), respectively,
- that the current mirror (cm) consists of a seventh transistor and an eighth transistor having their respective bases connected together and to the collector of the seventh transistor (t7),
- that the low end of the current mirror (cm) is connected to the common base lead (b), and
- that the fifth, sixth, seventh, and eighth transistors (t5, t6, t7, t8) are of the same conductivity type as the transistors of the push-pull output stage (gt).

5. A monolithic integrated wideband power amplifier as claimed in claim 4, characterized in that the load current (ib) is set by means of a constant-current sink (g) whose value is so chosen that the load-reducing transistor (te) is traversed by a current approximately equal to the first reference current (i5).

6. A monolithic integrated wideband power amplifier as claimed in any one of claims 1 to 5, characterized in that the layout of at least one of the planar bipolar NPN push-pull output stage transistors (t1, t2) contains N parallel-connected subtransistors (n1; n2) with the following features:
- The subtransistors (n1; n2) each comprise
-- a rectangular p⁺-type base subregion (bn),
-- two identical n⁺-type emitter subregions (en) arranged within the base subregion (bn) symmetrically with respect to a short axis of symmetry (ks) and a long axis of symmetry (ls) of the base subregion (bn) and each having an emitter contact (ek) in the middle, and
-- a base contact (bk) lying on, and extending in the direction of, the short axis of symmetry (ks), and
- the N base subregions (bn) lie side by side within an n⁻-type rectangular collector region (z1; z2), with their long axes of symmetry (ls) extending parallel to each other;
-- said n⁻-type rectangular collector region (z1; z2) has a plurality of collector contacts (kk) arranged either between the long sides of adjacent base subregions (bn) or along the two short sides of adjacent base subregions (bn), and
-- said n⁻-type rectangular collector region (z1; z2) contains, at least in the area of the collector contacts (kk), an n⁺-type contact region (k3; k4) which surrounds the respective base subregion (bn) within the collector region (z1;z2).

7. A monolithic power amplifier as claimed in any one of claims 1 to 5, characterized in that the layout of at least one of the planar bipolar NPN push-pull output stage transistors (t1, t2) contains a single or M parallel-connected subtransistors (tm) with the following features:
- a rectangular p⁺-type base element (bm) with an axis of symmetry (lm) in its longitudinal direction,
- an emitter subregion (en) lying symmetrically with respect to the axis of symmetry (lm) within the base element (bm) and having an emitter contact (ek) in the middle,
- a base contact (bk) lying symmetrically with respect to the axis of symmetry (lm) within the base element (bm), its longitudinal direction being perpendicular to the axis of symmetry (lm), and
- a common n⁻-type rectangular collector region (z3) containing the single base element (bm) or the M base elements (bm), with the axes of symmetry (lm) of the m base elements being parallel to each other,
-- each base element (bm) having at least one collector contact (kk) associated therewith which is located within the collector region (z3) along that short side of the base element (bm) which is adjacent to the base contact (bk), with the collector region (z3) having, at least in the contact area, an n⁺-type contact region (k5) which surrounds the respective base element (bm) within the collector region (z3).

8. A monolithic integrated wideband power amplifier as claimed in any one of claims 1 to 7, characterized in
- that the layout of the planar bipolar NPN push-pull output stage transistors (t1, t2) is designed as claimed in claim 6,
- that the transistor (t3) of the driver stage (tr) and the transistor (t4) of the operating-point setter (m) each have a layout as claimed in claim 7,
- that all subtransistors (n1; n2; tm) have identical emitter subregions (en), identical emitter contacts (ek), identical base contacts (bk), and identical collector contacts (kk),
- that one half of the base subregion (bn) which is limited by one of the short sides of the base and the short axis of symmetry (ks) and contains the emitter subregion (en) with the emitter contact (ek) and one half of the base contact (bk) is equal to that portion of the base element (bm) which is limited by the short side adjacent to the emitter and the parallel center line of the base contact (bk), and
- the distance between the edge of the base contact (bk) remote from the emitter and the associated short side of the base element (bm) is equal to the distance between the short side of the base contact and the adjacent edge of the base subregion (bn) or that of the base element (bm).

9. A monolithic integrated wideband power amplifier as claimed in at least one of claims 1 to 8, characterized in that the layout of the planar bipolar second, third and fourth resistors (r2, r3, r4) has the following features:
- The second, third, and fourth resistors (r2, r3, r4) each consist of at least one of identical rectangular n⁺-type resistor regions (rn) connected to the associated emitter subregions (en) of the second, third, and fourth transistors (t2, t3, t4), respectively;
- each resistor region (rn) contains two resistor contacts (wk), one at each of its two short sides;
- the resistor regions (rn) extend parallel to each other in the longitudinal direction and in the direction of the long axis of symmetry (ls, lm) and each have one resistor contact (wk) connected via an interconnection (lv) to the associated emitter contact (ek), while the other resistor contact (wk) is connected to a line (f2; f5, f5'; f6) running to the other terminal (-u) of the supply-voltage source, and
- the resistor regions (rn) and the collector region (z1; z2; z3) are disposed separately in the p⁻-type substrate (s).

10. A monolithic integrated wideband power amplifier as claimed in any one of claims 1 to 9, characterized in that the layout of at least one of the bipolar NPN push-pull output stage transistors (t1, t2) has the following features:
- The area of the emitter subregion (en) is a minimum area;
- the emitter contacts (ek) and the resistor contacts (wk) are equal-area minimum contacts;
- the distances of the emitter contacts (ek) from the edge of the associated emitter subregion (en) and the distances of the emitter subregions (en) from the adjacent edge of the base subregion (bn) or of the base element (bm) are a first minimum distance (m1) and a second minimum distance (m2), respectively;
- the short side of the base contact (bk) is a third minimum distance (m3);
- the minimum distance of the base contact (bk) from the adjacent edge of the base subregion (bn) or of the base element (bm) is a fourth minimum distance (m4), and
- the distance of the base contact (bk) from the emitter contact (ek) is a fifth minimum distance (m5).

## Revendications

1. Amplificateur de puissance à large bande intégré de façon monolithique, comportant :
un étage final symétrique (gt) constitué par des transistors bipolaires NPN, et
un étage différentiel (d) situé côté entrée et aux entrées duquel doit être appliquée une tension d'entrée (vi),
et dans lequel l'étage symétrique (gt) possède les caractéristiques suivantes :
- un étage final (p), qui contient des premier et second transistors (t1,t2), dont les voies collecteur-émetteur sont branchées en série dans le même sens et dont le point de jonction est le noeud de sortie (kn) pour la tension de sortie (vo), le collecteur du premier transistor (t1) étant connecté à un premier pôle (+u) d'une source de tension de fonctionnement et l'émetteur du second transistor (t2) étant couplé à l'autre pôle (-u),
- un étage d'attaque (tr), qui contient un troisième transistor (t3) présentant les connexions électriques suivantes :
-- l'émetteur du troisième transistor (t3) est couplé à l'autre pôle (-u),
-- la base du troisième transistor (t3) est raccordée à la base du second transistor (t2) par l'intermédiaire d'un conducteur de base (b), qui est couplé en outre à la sortie (vk) de l'étage différentiel (d), et
-- le collecteur du troisième transistor (t3) est raccordé à la base du premier transistor (t1) et, par l'intermédiaire de la première résistance (r1), au premier pôle (+u), et
- l'étage final symétrique (gt) contient en outre un circuit (m) de réglage du point de fonctionnement, qui comporte une résistance ohmique pour l'étage final (p),
caractérisé par les caractéristiques suivantes :
- le circuit (m) de réglage du point de fonctionnement contient une résistance de réglage (rr), qui est branchée entre le premier pôle (+u) et un noeud intermédiaire (zk), auquel sont raccordés le collecteur d'un quatrième transistor (t4), dont la base est connectée au conducteur de base commun (b), et la base d'un transistor de décharge (te), dont l'émetteur est raccordé au conducteur de base commun (b) et dont le collecteur est couplé au premier pôle (+u),
- l'étage différentiel (d) produit, à sa sortie (vk), un courant différentiel (id), dont la valeur est proportionnelle à la tension d'entrée (vi) et qui est envoyé par l'intermédiaire d'un conducteur de liaison au noeud intermédiaire (zk), ce dernier étant couplé par l'intermédiaire du quatrième transistor (t4) au conducteur de base commun (b),
- les émetteurs des second, troisième, et quatrième transistors (t2,t3,t4) étant raccordés à l'autre pôle (-u) par l'intermédiaire de seconde, troisième, et quatrième résistances (r2,r3,r4), dont la valeur respective est inversement proportionnelle à la surface de l'émetteur associé, et
- un courant de charge (ib) est prélevé du conducteur de base commun (b).

2. Amplificateur de puissance à large bande intégré de façon monolithique selon la revendication 1, caractérisé en ce que l'intensité du courant différentiel (id) est réglée à l'aide d'une cinquième résistance et d'une sixième résistance identique (r5,r6).

3. Amplificateur de puissance à large bande intégré de façon monolithique selon la revendication 2, caractérisé en ce que l'étage différentiel (d) comporte :
- un premier convertisseur tension-courant (w1) comportant un premier transformateur d'impédance, qui est raccordé, côté entrée, à une première borne d'entre (k) et qui produit un premier courant de référence (i5), au moyen de la cinquième résistance (r5), qui est branchée en aval de ce transformateur,
- un second convertisseur tension-courant (w2) qui comporte un second transformateur d'impédance, qui est raccordé côté entrée à une seconde borne d'entrée (k2) et qui produit un second courant de référence (i6), au moyen de la sixième résistance (r6), qui est branchée en aval de ce transformateur, et
- un miroir de courant (cm), dont l'entrée est alimentée par le premier courant de référence (i5) et dont la sortie est connectée à un noeud d'embranchement (vk), qui est alimenté par le second courant de référence (i6) et est raccordé au noeud intermédiaire (zk).

4. Amplificateur de puissance à large bande intégré de façon monolithique selon la revendication 3, caractérisé en ce :
- que les premier et second transformateurs d'impédance sont formées chacun par un émetteur-suiveur constitué par un cinquième ou un sixième transistor (t5,t6) et à l'émetteur respectif duquel est raccordée la cinquième ou la sixième résistance (r5,r6),
- que le miroir de courant (cm) est constitué par des septième et huitième transistors, dont les bases sont connectées entre elles et au collecteur du septième transistor (t7),
- que le point de base du miroir de courant (cm) est raccordé au conducteur de base commun (b), et
- que les cinquième, sixième, septième et huitième transistors (t5,t6,t7,t8) possèdent respectivement le même type de conduction que les transistors de l'étage final symétrique (gt).

5. Amplificateur de puissance à large bande intégré de façon monolithique selon la revendication 4, caractérisé en ce que le courant de charge (ib) est réglé au moyen d'un puits de courant constant (g), dont la valeur est choisie de telle sorte que dans le transistor de décharge (te) circule un courant qui est égal approximativement au premier courant de référence (i5).

6. Amplificateur de puissance à large bande intégré de façon monolithique selon l'une des revendications 1 à 5 caractérisé en ce que l'agencement d'au moins l'un des transistors NPN bipolaires planar (t1,t2) de l'étage final symétrique contient N transistors partiels (n1;n2) branchés en parallèle et possédant les caractéristiques suivantes :
- les transistors partiels (n1;n2) contiennent chacun
-- une zone partielle de base rectangulaire (bn) conductrice du type p⁺,
--- deux zones partielles identiques d'émetteur (en) conductrices du type n⁺, qui sont disposées à l'intérieur de la zone partielle de base (bn) symétriquement par rapport à un axe de symétrie transversal (ks), formé par cette zone, et par rapport à un axe de symétrie longitudinal (ls) formé également par cette zone et qui possèdent, en leur centre, respectivement un contact d'émetteur (ek), et
-- un contact de base (bk) qui s'étend dans la direction longitudinale sur l'axe de symétrie transversal (ks), et
- les N zones partielles de base (bn) sont disposées côte-à-côte en étant alignées parallèlement à l'axe de symétrie longitudinal (ls), à l'intérieur d'une zone rectangulaire de collecteur (z1;z2) conductrice du type n⁻,
-- cette zone possède une multiplicité de contacts de collecteur (kk), qui sont disposés soit côte-à-côte et entre les grands côtés, soit le long des deux petits côtés de zone partielle voisine de base (bn), et
-- cette zone de collecteur contient au moins, dans la région du contact de collecteur (kk), une zone de contact (k3;k4) conductrice du type n⁺, qui entoure en outre avec une forme annulaire la zone partielle respective de base (bn), à l'intérieur de la zone de collecteur (z1;z2).

7. Amplificateur de puissance à large bande intégré de façon monolithique selon l'une des revendications 1 à 5, caractérisé en ce que l'agencement d'au moins l'un des transistors NPN bipolaires planar (t1,t2) de l'étage final symétrique contient un seul transistor partiel ou M transistors partiels (tm) branchés en parallèle, avec les caractéristiques suivantes :
- un élément de base rectangulaire (bm) conducteur du type p⁺, possédant un axe de symétrie (lm) s'étendant dans sa direction longitudinale,
- une zone partielle d'émetteur (en), qui est située à l'intérieur de l'élément de base (bm), symétriquement par rapport à l'axe de symétrie (lm) et qui possède, en son centre, un contact d'émetteur (ek),
- un contact de base (bk), qui est disposé symétriquement par rapport à l'axe de symétrie (lm) à l'intérieur de l'élément de base (bm) et dont la direction longitudinale est perpendiculaire à cet axe, et
- une zone de collecteur rectangulaire commune (z3) conductrice du type n⁻, dans laquelle sont situés un ou les M éléments de base (bm), qui sont disposés dans le même sens, parallèlement aux axes de symétrie (lm), et
-- au moins pour chaque élément de base (bm) un contact de collecteur (kk), qui est disposé à l'intérieur de la zone de collecteur (c3) le long du petit côté de base voisin du contact de base (bk), la zone de collecteur (z3) possédant au moins dans la région de contact, une zone de contact (k5) conductrice du type n⁺, qui en outre entoure avec une forme annulaire; l'élément de base respectif (bm), à l'intérieur de la zone de collecteur (z3).

8. Amplificateur de puissance à large bande intégré de façon monolithique selon l'une des revendications 1 à 7, caractérisé en ce que
- l'agencement des transistors NPN bipolaires planar (t1,t2) de l'étage final symétrique est réalisé conformément à la revendication 6,
- le transistor (t3) de l'étage d'attaque (tr) et le transistor (t4) du circuit (m) de réglage du point de fonctionnement possèdent respectivement un agencement selon la revendication 7,
- tous les transistors partiels (n1;n2;tm) contiennent des zones partielles d'émetteur identiques (en), des contacts d'émetteur (ek) identiques, des contacts de base (bk) identiques et des contacts de collecteur (kk) identiques,
- une première moitié de la zone partielle de base (bn), qui est limitée par l'un des petits côtés de base et l'axe transversal de symétrie (ks) et qui contient la zone partielle d'émetteur (en) équipée du contact d'émetteur (ek) et une première moitié du contact de base (bk), est identique à la partie de l'élément de base (bm), qui est limitée par le petit côté de base situé côté émetteur et par l'axe médian, parallèle à ce côté, du contact de base (bk), et
- la distance, comptée sur le côté opposé à l'émetteur, entre le bord du contact de base (bk) de l'élément de base (bm) et le bord de la zone partielle de base (bm) est égal à la distance respective, du petit côté du contact de base par rapport au bord de cette zone partielle de base (bn) ou par rapport au bord de l'élément de base (bm).

9. Amplificateur de puissance à large bande intégré de façon monolithique selon au moins l'une des revendications 1 à 8, caractérisé en ce que l'agencement des seconde, troisième, et quatrième résistances bipolaires planar (r2,r3,r4) possède les caractéristiques suivantes :
- les seconde, troisième et quatrième résistances (r2,r3,r4) sont constituées par respectivement au moins l'une de zones résistives rectangulaires identiques (rn) conductrices du type n⁺, qui sont raccordées respectivement aux zones partielles associées d'émetteur (en) des second, troisième, et quatrième transistors (t2,t3,t4),
- chaque zone résistive (rn) contient respectivement un contact de résistance (wk) au niveau des deux petits côtés,
- les zones résistives (rn) sont orientées parallèlement entre elles respectivement dans la direction longitudinale et dans la direction de l'axe longitudinal de symétrie (ls) ou de l'axe de symétrie (lm) et sont connectées respectivement au niveau d'un contact de résistance (wk), par l'intermédiaire d'un conducteur de liaison (lv), au contact d'émetteur associé (ek) et, respectivement au niveau de l'autre contact de résistance (wk), à un conducteur (f2;f5,f5';f6) aboutissant à l'autre pôle (-u), et
- les zones résistives (rn) et la zone de collecteur (z1;z2;z3) sont disposées en étant respectivement séparées dans le substrat (s) conducteur de type p⁻.

10. Amplificateur de puissance à large bande intégré de façon monolithique selon l'une des revendications 1 à 9, caractérisé en ce que l'agencement d'au moins l'un des transistors NPN bipolaires planar (t1,t2) de l'étage final possède les caractéristiques suivantes :
- la surface de la zone partielle d'émetteur (en) est une surface minimale,
- les contacts d'émetteur (ek) et les contacts de résistance (wk) sont des contacts minimum ayant des surfaces identiques,
- les distances des contacts d'émetteur (ek) par rapport au bord de la zone partielle associée d'émetteur (en) ou les distances de la zone partielle d'émetteur (en) par rapport au bord associé de la zone partielle de base (bn) ou par rapport au bord de l'élément de base (bm) sont des première et seconde distances minimales (m1,m2),
- le petit côté du contact de base (bk) est une troisième distance minimale (m3),
- la distance minimale entre le contact de base (bk) et le bord associé de la zone partielle de base (bn) ou de l'élément de base (bm) est une quatrième distance minimale (m4), et
- la distance entre le contact de base (bk) et le contact d'émetteur (ek) est une cinquième distance minimale (m5).
